# FASCICULE DE BREVET EUROPEEN

(11) **EP 0 324 700 B1**
(45) Date de publication et mention de la délivrance du brevet: **15.09.1993**
(21) Numéro de dépôt: 89420011.2
(22) Date de dépôt: 09.01.1989
(51) Int. Cl.: G06K 19/077, H01L 21/50

(54) **Boîtier destiné à contenir un élément fragile tel qu'un circuit logique et procédé d'assemblage d'un tel boîtier**
Gehäuse zur Umhüllung eines zerbrechlichen Elementes, wie einer logischen Schaltung und Verfahren zur Montage eines derartigen Gehäuses
Housing for enclosing a fragile element, such as a logic circuit, and method for assembling such a housing

(30) Priorité: 13.01.1988 FR 8800462
(43) Date de publication de la demande: 19.07.1989
(73) Titulaire: SGS-THOMSON MICROELECTRONICS S.A., 94250 Gentilly (FR)
(72) Inventeur: Steffen, Francis, F-73100 Aix les Bains (FR)
(74) Mandataire: de Beaumont, Michel

(56) Documents cités:
- EP-A- 0 233 649
- FR-A- 2 457 623
- FR-A- 2 586 886
- GB-A- 2 081 644

## Description

La présente invention vise, d'une manière générale, un boîtier destiné à contenir, notamment, au moins un élément fragile, tel qu'un circuit logique. Elle vise également le procédé d'assemblage d'un tel boîtier.

Plus particulièrement la présente invention concerne un boîtier se présentant sous la forme d'une carte de crédit et s'inscrit dans le développement des cartes porteuses de circuits logiques susceptibles d'assurer plusieurs fonctions telles que cartes d'accès à des zones contrôlées, cartes bancaires ou autres.

D'une manière générale les boîtiers selon l'invention sont du type comportant deux coquilles et un support destiné à porter le circuit logique. S'agissant du développement particulier également visé par la présente invention, le boîtier se présente sous forme de deux coquilles globalement plates, présentant, globalement, la forme d'une carte de crédit, tandis que le support incorpore également un connecteur destiné à permettre le raccordement de la logique de la carte à une logique extérieure. Les coquilles et le support sont de préférence réalisés en matière plastique.

Le problème technique général auquel s'est trouvé confrontée la demanderesse, est celui de l'assemblage final des coquilles et du support.

Diverses solutions sont connues. Elles ont toutes en commun de faire appel à des techniques de collage mettant en oeuvre soit de la colle, soit des films enduits de colle. Ces techniques présentent divers inconvénients.

Tout d'abord l'efficacité du collage n'est pas toujours bonne car les matériaux en présence ne sont pas toujours propres et parfaitement plans. En effet le collage est lié à l'énergie de surface de la colle et à celle des matériaux à coller. L'énergie de surface de la colle est en général constante. Cependant, celle des matériaux à coller est susceptible d'évoluer d'un lot de matière à l'autre. Il est donc assez difficile de reproduire d'un lot à l'autre des conditions de collage identiques, ce qui nécessite un traitement particulier des lots et ce qui, outre des inconvénients économiques, a pour effet de rendre aléatoire la qualité du collage.

Un autre inconvénient est lié au fait que la liaison par collage reste facilement destructible surtout dans le cas de soumission de la carte à des cycles thermiques importants. A cet égard, les cartes visées par la présente invention doivent être susceptibles de résister à des variations de température de l'ordre d'une centaine de degrés. De même, les cartes selon l'invention doivent être susceptibles de résister à des contraintes mécaniques importantes. Comme, en plus, les différentes colles accessibles sur le marché ont chacune leurs avantages et leurs inconvénients propres, il devient souvent difficile de concilier la tenue de multiples données imposées par le cahier des charges comme par exemple résistance au froid, à la flexion, aux solvants, à la pollution ...

Enfin, il faut savoir que la mise en oeuvre du collage n'est pas toujours aisée. En effet, l'homme de l'art est confronté à des problèmes de pollution pour les composants ou pour les hommes. Il est également confronté à des problèmes de temps d'encollage qui ne sont pas toujours faciles à maîtriser dans une chaîne de fabrication.

Par ailleurs, l'homme de l'art connaît également une autre technique d'assemblage d'éléments en matière plastique : la soudure par ultrasons.

Cette technique, qui permet d'assembler des éléments en matière plastique en fusionnant la matière au niveau du joint, permet de pallier les inconvénients rapelés plus haut. Elle a été proposée dans le document FR-A-2457623. Elle présente toute-fois des inconvénients. En effet, l'essence même du procédé est de faire vibrer, à une fréquence ultrasonique (de l'ordre de 20 à 50 kHz) la zone de soudage, en l'espèce la périphérie du boîtier plan. Or, avec les techniques connues, les vibrations seraient transmises à l'ensemble du boîtier. Comme il s'agit, en l'espèce de l'assemblage de deux coquilles plates prenant en sandwich un circuit logique, les vibrations seraient transmises au circuit logique avec pour résultat quasi certain la destruction des éléments fragiles que comporte ce circuit. Cela serait également vrai dans le cas où le support du circuit comporte également un connecteur. En effet, de nombreuses liaisons par soudure sont alors prévues entre les éléments du circuit logique et des broches du conducteur, ces soudures risquant d'être détruites ou, à tout le moins détériorées, dans le cas où on les soumettrait, même pendant un temps très court, à des vibrations du type de celles énoncées ci-dessus.

C'est pourquoi, dans un premier temps la demanderesse avait orienté ses recherches vers des techniques du type collage. Cependant, en dépuit du fait que pour l'homme de l'art, la soudure à ultrasons semblait totalement inappropriée pour résoudre son problème d'assemblage, pour les raisons évoquées plus haut, la demanderesse a entrepris de rechercher une solution permettant de faire l'assemblage par soudure aux ultrasons tout en empêchant autant que possible les vibrations ultrasoniques d'amplitude dangereuse d'être transmises aux éléments fragiles que doit contenir le boîtier, qu'il s'agisse de certains éléments du circuit logique, des soudures du connecteur ou de tout autre élément fragile. Parallèlement la demanderesse a poursuivi ses recherches pour améliorer la tenue des caractéristiques techniques imposées par le cahier des charges aux cartes porteuses de circuits logiques, notamment leur capacité à subir des flexions.

La présente invention propose une solution à ce double problème technique puisqu'elle vise en boîtier destiné à contenir, notamment, au moins un élément fragile tel qu'un circuit logique monté sur un support, Le boîtier comportant le support et au moins deux coquilles devant être assemblées par soudure aux ultrasons, caractérisé en ce que chaque coquille comporte à cet effet au moins une zone de soudure, de géométrie appropriée pour permettre le soudage par ultrasons, et telle que lorsque les deux coquilles sont préassemblées avant l'opération de soudure, un décalage orienté le long d'un premier axe dit axe vertical sépare globalement les coquilles, et en ce que ledit support comporte au moins une portion de montage tandis que l'une au moins des coquilles comporte un logement pour cette portion, les logement et portion de montage coopérant en sorte que, d'une part le débattement du support Par rapport aux coquilles le long de deux axes respectivement dits transversal et axial est limité respectivement à un jeu transversal et axial et, d'autre part, après l'opération de soudage, le débattement du support Par rapport aux coquilles le long de l'axe vertical est limité à un jeu vertical.

La présente invention vise également un procédé d'assemblage d'un boîtier tel que succinctement décrit ci-dessus, consistant à :
- préassembler les deux coquilles et le support,
- presser l'une contre l'autre les coquilles au moyen, notamment, d'un dispositif de soudage aux ultrasons,
- faire vibrer la zone de soudure au moyen du dispositif de soudage en orientant les vibrations ultrasoniques selon ledit axe vertical,
- arrêter les vibrations dès que ledit décalage selon l'axe vertical est annulé.

Grâce à ces dispositions, on réalise un boîtier, contenant au moins un élément fragile pouvant être assemblé, par soudure aux ultrasons. De ce fait les inconvénients des techniques de type "collage" sont palliés. De plus, s'agissant du boîtier en forme de carte de crédit développé par la demanderesse, on en améliore la tenue aux contraintes imposées au cahier des charges.

Ainsi, s'agissant de la tenue de l'ensemble aux vibrations ultrasoniques, lors de l'opération de soudage, il convient d'observer que grâce au décalage entre les coquilles en début de soudage selon un axe, dit vertical, parallèle à l'amplitude des vibrations, on évite que ces dernières soient transmises directement au support et par conséquent aux éléments fragiles que ce dernier supporte.

On observera ensuite que la portion de montage du support se trouve encastrée et non pas soudée dans le logement. De plus, tout au moins dans certains modes de réalisation, il est prévu de laisser un léger jeu en sorte que la portion de montage du support peut se mouvoir dans plusieurs directions à l'intérieur du logement, pendant et après l'opération de soudage. Ces dispositions ont pour avantage de réduire encore plus les points de transmission des vibrations entre les coquilles et la portion de montage. On conçoit en effet que si l'on évite de bloquer, par encastrement sans jeu, la portion de montage du support, on évite par la même occasion d'avoir des vibrations transmises de façon directe ou indirecte par le moyen d'encastrement.

Par ailleurs, grâce à l'invention, on réalise un boîtier homogène sans éléments étrangers et sans interfaces entre les coquilles. Un tel boîtier se comporte d'une façon homogène dans différentes situations d'atmosphère ou de conditions climatiques. Ainsi, le procédé d'assemblage permet d'étendre la tenue du boîtier en forme de carte aussi bien vers les basses températures que vers les hautes températures, la gamme de stockage passant de - 40°C, + 85°C avec les techniques antérieures à - 55°C, + 150°C ou même plus si nécessaire, en fonction des matériaux utilisés. De plus, quand c'est souhaité, on obtient une étanchéité réelle de la carte après soudure.

Un autre avantage réside dans la présence d'un léger jeu après soudage, notamment dans une direction verticale mais également, lorsque cela est possible, dans les directions axiale et transversale. Ce jeu permet, s'agissant d'un boîtier présentant la forme globale d'une carte de crédit, d'améliorer la capacité du boîtier à subir des flexions. En effet, lorsque le boîtier subit une flexion, le circuit logique, qui se présentera le plus souvent sous la forme d'une petit circuit imprimé plan, peut se décaler dans les directions considérées, en compensant ainsi une partie au moins de la flexion.

Les problèmes de fabrication évoqués plus haut sont résolus puisque le procédé d'assemblage est propre et rapide, sans pollution et que les conditions d'assemblage sont reproductibles, sans aléas.

Enfin les avantages ci-dessus ont une incidence financière importante puisqu'aussi bien les temps de fabrication (la soudure ne dure que quelques millisecondes) que l'automatisation et, d'une manière générale, la facilité du procédé, permettent d'optimiser les coûts.

Dans quelques applications il n'est pas souhaitable qu'après assemblage et soudage de l'ensemble, le support soit libre de se mouvoir dans une ou plusieurs directions. C'est pourquoi, dans certains modes de réalisation de l'invention, l'un au moins des jeux transversal, axial et vertical est nul. Toutefois, conformément à l'invention, le jeu vertical ne peut être annulé qu'une fois l'opération de soudage terminée, pour éviter que les vibrations ultrasoniques soient transmises directement au support pendant le soudage.

Dans un mode de réalisation préféré, la portion de montage comporte une oreille de montage, sensiblement parallélépipédique s'étendant globalement selon un plan transversal - axial, tandis que le logement est de forme sensiblement complémentaire, les dimensions relatives de l'oreille de montage et du logement étant telles que, d'une part, la hauteur de l'oreille est au plus égale à la hauteur totale du logement de cette oreille une fois le boîtier soudé et que, d'autre part, l'oreille comportant, à son extrémité transversale la plus proche de la zone de soudure, une face latérale orientée selon un plan axial - vertical, aucun contact n'est possible entre cette face latérale et la face correspondante du logement.

Ces dispositions sont particulièrement simples à mettre en oeuvre mais en plus les vibrations ne peuvent être transmises ni de façon directe ni de façon indirecte par ladite face latérale.

Selon une autre caractéristique de ce mode préféré de réalisation, chaque coquille comporte une encoche adaptée à loger le support, tandis que ce dernier comporte deux portions de montage, ces portions de montage étant associées chacune à une face latérale d'extrémité du support, l'encoche comportant elle-même deux faces latérales correspondantes, les dimensions relatives de l'encoche et du support sont telles qu'aucun contact concomitant n'est possible entre chacune, les faces latérales d'extrémité de support ne pouvant être simultanément en contact avec les faces correspondantes de l'encoche.

Ces dispositions permettent d'éviter notamment que, pendant l'opération de soudage, le support se trouve encastré et bloqué dans un sens transversal et qu'ainsi des vibrations soient transmises de façon au moins indirecte au support par l'intermédiaire de ses faces latérales d'extrémité.

Dans ce mode de réalisation, le support est bloqué en sens axial, les oreilles de montage présentant chacune une face avant et une face arrière s'étendant, selon un plan vertical - transversal, venant en butée contre des faces correspondantes que comportent les logements. Ainsi les vibrations éventuellement transmises par ces faces rayonnent essentiellement selon une direction axiale et par conséquent sont très atténuées dans la direction transversale vers l'intérieur du support.

Avantageusement, on arrondit les arêtes de l'oreille de montage, ce qui permet notamment d'éviter les effets de pointe et d'augmenter ainsi encore plus l'atténuation des vibrations.

Dans ce mode préféré de réalisation, selon une caractéristique particulièrement avantageuse, les coquilles d'une part et la portion de montage d'autre part sont réalisées dans des matières distinctes non susceptibles d'être amalgamées au cours d'une opération de soudure aux ultrasons.

Ainsi, on évite que la portion de montage se trouve accidentellement soudée dans le logement, ce qui permet, d'une part, d'éviter que des vibrations soient transmises par cette soudure accidentelle avant la fin de l'opération de soudage et, d'autre part, d'éviter de bloquer le support alors que dans certaines applications, on souhaite que ce dernier puisse être mobile selon une ou plusieurs directions comme exposé plus haut.

Les caractéristiques et avantages de la présente invention ressortiront d'ailleurs de la description qui va suivre en référence aux dessins annexés sur lesquels :
- la figure 1 est une vue éclatée en perspective d'un mode de réalisation d'un boîtier selon l'invention,
- la figure 2 est une vue de détail de l'une des coquilles et de la portion de montage du support illustré en figure 1, selon la ligne II-II de la figure 3,
- la figure 3 est une coupe partielle selon la ligne III-III de la figure 2, les coquilles étant préassemblées avant soudage,
- la figure 4 est une coupe partielle selon la ligne IV-IV de la figure 2, les coquilles étant préassemblées avant soudage,
- la figure 5 est un diagramme montrant l'amortissement des vibrations transmises au support pendant l'opération de soudage,
- la figure 6 est une vue analogue à la figure 3 mais illustre l'ensemble après soudage, et
- la figure 7 est une vue correspondant à la figure 3 et illustre une variante de réalisation.

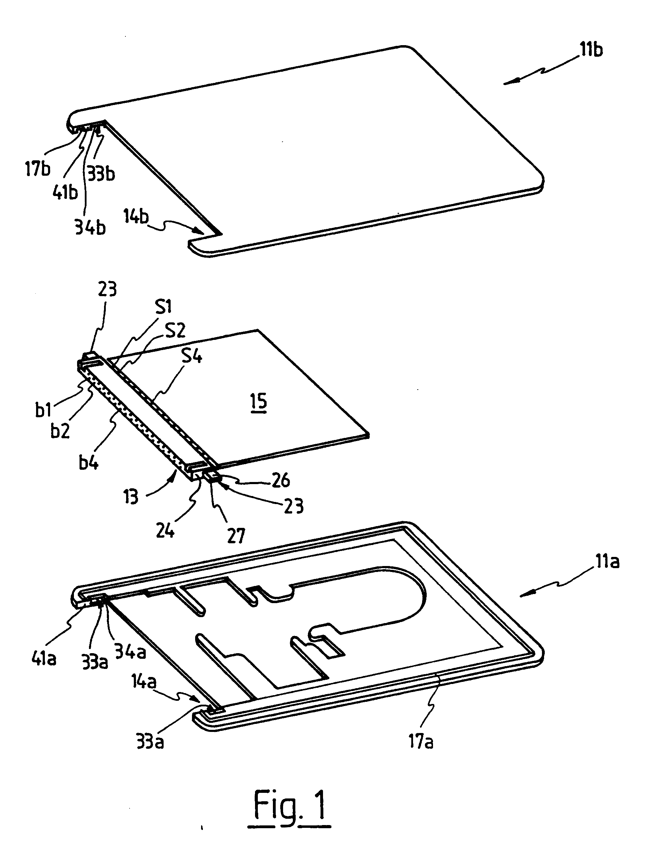

Selon le mode de réalisation choisi et représenté aux figures 1 à 4, un boîtier 10 comporte deux coquilles, l'une dite inférieure, 11a, l'autre dite supérieure, 11b, et un support 13, portant un circuit logique, se présentant ici sous la forme d'un circuit imprimé 15. Les coquilles 11a, 11b, sont globalement planes et ont une longueur et une largeur correspondant au standard des cartes de crédit.

On observe qu'ici chaque coquille comporte, sur l'un de ses petits côtés, un logement 14a (14b), de forme sensiblement rectangulaire, chacun de ces logements étant adapté à recevoir le support 13 qui reste apparent à l'extérieur dans ce mode de réalisation. On observe également que le support 13 incorpore aussi un connecteur, comportant ici des broches femelles référencées b1, b2 sur le dessin. Dans ce mode de réalisation, ce sont les soudures S1, S2, .... Sn liant les broches au circuit 15 qui ont pour fonction d'assurer la liaison entre le circuit 15 et le support 13.

L'invention concerne l'assemblage des coquilles et du support.

A cet effet, chaque coquille comporte une zone de soudure (17a, 17b), de géométrie appropriée pour permettre le soudage par ultrasons.

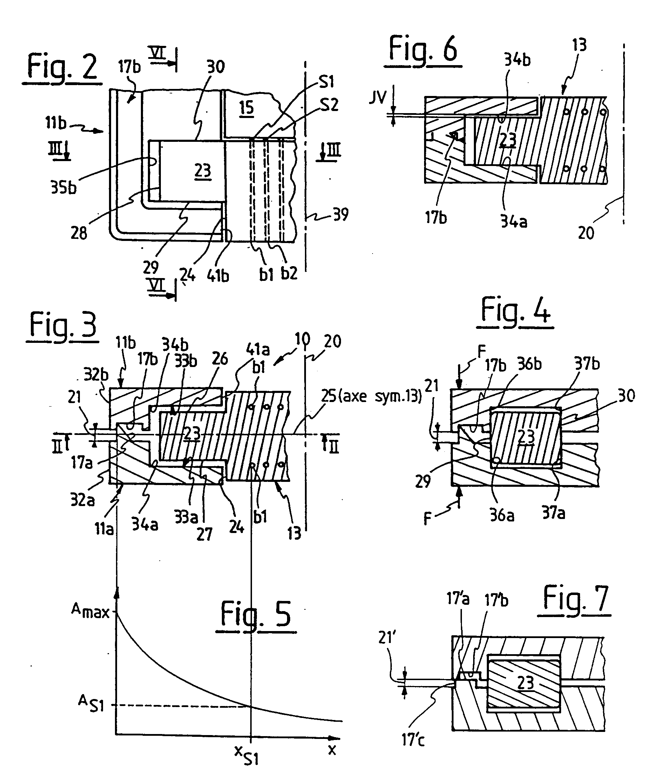

Les coquilles étant, dans le mode de réalisation décrit, réalisées en ABS, cette zone de soudure présente, sur chacune des coquilles 11a, 11b, un profil particulier destiné à permettre et à faciliter cette soudure. On observe qu'ainsi, sur la coquille inférieure 11a, la zone de soudure 17a, se présente sous la forme d'une arête tranchante, tandis que sur la coquille supérieure, la zone de soudure 17b est en forme de creux présentant une section sensiblement rectangulaire, figures 2 et 3. Ces zones 17a, 17b s'étendent sur la périphérie de la coquille, sauf au niveau des côtés formant les encoches 14a, 14b.

La géométrie des zones de soudure 17a, 17b est bien visible en figure 3. On observe notamment sur cette figure que, selon une caractéristique de l'invention, la géométrie de la zone de soudure de chacune des coquilles est telle que lorsque les deux coquilles sont assemblées, avant l'opération de soudure, comme représenté en figure 2, elles se trouvent décalées le long d'un premier axe, dit "vertical" et portant ici la référence 20. Le décalage des deux coquilles porte la référence 21 sur la figure 2.

La géométrie de la zone de soudure 17a, 17b illustrée sur les figures 1 à 3 n'est pas la seule possible. En effet cette géométrie dépend d'une part, de la matière utilisée (en l'espèce de l'ABS) et des dimensions des pièces à souder. L'homme de l'art, qui connaît la soudure aux ultrasons, pourra donc déterminer au cas par cas le profil de la zone de soudure à adopter. Cependant, conformément à l'invention, il faut que le profil adopté soit tel qu'il génère un décalage le long de l'axe 20 des deux demi-coquilles, au moins au niveau de la zone de montage du support ainsi qu'il ressortira de la description qui en est faite plus loin.

A titre d'exemple on a représenté en figure 7 un autre profil pouvant être utilisé, si les coquilles sont réalisées en nylon. On observe que les zones de soudure 17′a, 17′b présentent un profil en L mais qu'en début de soudure un chevauchement 17′c de la matière génère un décalage 21′.

Selon l'invention le support 13 comporte au moins une zone de montage. Dans le mode de réalisation choisi et représenté, la zone de montage est essentiellement constituée par une oreille également dite "de montage", portant la référence 23 sur les figures 1 à 4. On observe, figure 1, que le support 13 comporte une oreille latérale d'extrémité. Ces oreilles sont identiques et on ne décrira que celle de gauche, représentée en détail aux figures 2 à 4.

L'oreille de montage 23 est moulée d'une seule pièce avec le support 13. Elle présente une forme globalement parallélépipèdique et elle est disposée sur chaque face latérale d'extrémité 24 du support 13, sensiblement dans un plan médian schématisé en figure 3 par l'axe transversal 25.

L'oreille 23 comporte cinq faces extérieures : une face supérieure 26, une face inférieure 27, une face latérale 28, une face avant 29 et une face arrière 30.

On observe sur les figures que les faces supérieure 26 et inférieure 27 sont globalement planes et s'étendent selon des plans parallèles à ceux des coquilles 11a et 11b. La face latérale 28 s'étend selon un plan sensiblement vertical, parallèle à l'axe 20. Elle est également parallèle aux bords longitudinaux des coquilles. Les faces avant 29 et arrière 30 sont d'orientation verticale et perpendiculaire aux faces précédemment décrites.

Selon l'invention, l'une au moins des coquilles 11a, 11b comporte un logement pour la portion de montage.

Dans le mode de réalisation choisi et représenté, chaque coquille comporte un tel logement (références 33a, 33b). Chacun des logements 33a, 33b comporte une face d'appui horizontale 34a, (34b), une face latérale 35a, (35b), une face frontale d'extension verticale 36a, (36b) et une face arrière d'extension verticale 37a, (37b).

Selon un aspect de l'invention mis en oeuvre dans le mode de réalisation présentement décrit, on observe, figures 2 et 4, que la distance séparant les faces avant 29 et arrière 30 de l'oreille 23 est la même que celle séparant les faces frontale 36a, 36b et arrière 37a, 37b des logements 33a, 33b, en sorte que, selon une caractéristique d'un aspect de l'invention mis en oeuvre dans ce mode de réalisation, le support 13 se trouve bloqué dans le sens axial (schématisé en figure 2 par l'axe 39).

Selon un autre aspect de l'invention, les oreilles 23 présentent une extension latérale (selon l'axe transversal 25), sensiblement inférieure à l'extension latérale des logements 33a, 33b. De même la longueur du support 13, entre ses faces latérales d'extrémité 24, est sensiblement inférieure à la distance entre les faces latérales 41a, 41b de l'encoche 14 : ainsi que le boîtier soit simplement assemblé, avant soudage, figure 3, ou qu'il soit soudé, figure 6, le support 13 peut se mouvoir transversalement (selon l'axe 25), et son débattement est limité par la butée des faces 24 du support contre les faces latérales de l'encoche 41a, 41b.

On observe qu'ainsi, dans le mode de réalisation décrit et représenté, et selon une caractéristique particulièrement avantageuse d'un aspect de l'invention,d'une part, il ne peut y avoir aucun contact entre la face latérale 28 de l'oreille 23 et la face latérale 35a ou 35b du logement 33a ou 33b et, d'autre part, le support 13 ne peut se trouver en contact avec les coquilles 11a, 11b simultanément par chacune de ses faces latérales 24.

Selon l'invention, l'épaisseur de l'oreille 23, c'est-à-dire la distance séparant ses faces supérieure 26 et inférieure 27 est au plus égale à la distance séparant les faces horizontales d'appui 34a, 34b des logements 33a, 33b lorsque les coquilles sont soudées. Dans ce cas, à la fin de la soudure, il y a un contact simultané entre les faces supérieure 26 et inférieure 27 de l'oreille 23 respectivement avec la face d'appui 34a de la coquille inférieure 11a et la face d'appui 34b de la coquille supérieure 11b. Cependant, dans le mode de réalisation choisi et représenté, l'épaisseur de l'oreille 23 est choisie de telle sorte qu'elle est sensiblement inférieure à la distance séparant les faces horizontales 34a, 34b, après soudage, figure 6. Ainsi, après soudage des coquilles, le support 13 est mobile le long de l'axe vertical 20 mais il est limité au jeu JV illustré en figure 6.

On va maintenant décrire le procédé d'assemblage proprement dit.

Tout d'abord, on préassemble, comme illustré en figures 3 et 4, les coquilles 11a, 11b et le support 13, sur lequel le circuit 15 aura été préalablement monté.

Ensuite, d'une manière connue en soi, on dispose les coquilles 11a, 11b entre un support et une sonotrode en sorte qu'une pression est exercée sur les coquilles, cette pression ayant été schématisée en figure 4 par les flèches F. Comme illustré en figures 3 et 4, au début de l'opération de soudage, alors que les coquilles sont assemblées, les coquilles 11a, 11b sont séparées par le décalage 21. Ceci a pour effet que, même si l'épaisseur de l'oreille 23 est sensiblement égale à la hauteur de l'ensemble du logement 33a, 33b après soudage, en début de soudage, un jeu vertical au moins égal au décalage 21 existe et le support peut se mouvoir selon l'axe vertical dans la limite de ce jeu.

Comme on l'a vu, un jeu transversal existe en sorte que les faces latérales 24 du support ne peuvent pas être concomitamment en contact l'une et l'autre avec les faces latérales 41a, 41b des encoches 14a, 14b. De plus aucun contact n'est possible entre la face latérale 28 de l'oreille et les faces latérales 35a et 35b des logements 33a, 33b.

On fait ensuite vibrer la sonotrode. Selon une caractéristique du procédé, les vibrations sont orientées dans un plan vertical (parallèle à laxe 20). Aussi les vibrations ne peuvent pas être directement transmises aux faces supérieure 26 et inférieure 27 de l'oreille 23 puisque cette dernière n'est pas pincée entre les coquilles. De même, pour les raisons évoquées plus haut, aucune des vibrations ne peut être transmise soit par la face latérale 28 de l'oreille 23, soit par les faces latérales 24 du support.

Ainsi, dans le mode de réalisation présentement décrit, au début de l'opération de soudure, seules les faces avant 29 et arrière 30 de l'oreille 23 sont en contact avec les faces correspondantes du logement 33a ou 33b, figures 2 et 4. Or comme l'amplitude des vibrations s'étend parallèlement à ces faces, et qu'en plus ces dernières sont en regard l'une de l'autre, les vibrations transmises par ces faces se propagent essentiellement dans une direction axiale et quasiment pas dans la direction transversale.

En figure 5, on a représenté sur un diagramme l'amplitude des vibrations au niveau du joint de soudure 17a, 17b et la valeur de cette amplitude en fonction de l'éloignement dans un sens transversal, par rapport à la zone 17a, 17b. On observe qu'au niveau de la premère soudure S1 (abscisse x_{S1} sur la figure 5), l'amplitude des vibrations est fortement atténuée (amplitude A_{S1}). En fait la demanderesse a constaté qu'il y a en x_{S1} une atténuation d'environ 40 dB par rapport à l'amplitude Aₘₐₓ des vibrations au niveau de la zone de soudure. Une telle atténuation est ici suffisante pour éviter que la soudure S1 ne soit détériorée. Mais on observe que plus l'on s'éloigne de la zone de soudure, plus l'atténuation est élevée. Si, dans le circuit imprimé, des éléments encore plus fragiles doivent être montés, il suffira, dans le cadre du mode de réalisation présentement décrit, de les disposer en un endroit où l'atténuation est encore plus conséquente.

Les vibrations ultrasoniques sont appliquées pendant un temps assez court (ici de l'ordre de quelques dixièmes de seconde ). L'énergie vibratoire se concentre, de façon connue en soi, sur l'arête 17a et a pour effet de fusionner la matière de cette arête avec la zone 17b de la coquille supérieure. Comme une pression verticale F est exercée sur les coquilles, ces dernières se rapprochent et le décalage 21 s'amenuise puis s'annule.

A la fin de l'opération de soudage, l'arête de soudage 17a de la coquille inférieure 11a est entièrement fusionnée et la matière qui constituait cette arête vient se loger dans le renfoncement de la zone de soudure 17b, comme illustré en figure 6.

Selon une caractéristique avantageuse de l'invention telle que mise en oeuvre ici, on arrête les vibrations à l'instant où le décalage 21 est annulé. Grâce à cette disposition, dans l'hypothèse où l'épaisseur de l'oreille 23 est égale à la hauteur de l'ensemble du logement 33a, 33b après soudure, on évite ainsi de transmettre, même pendant un temps très bref, des vibrations ayant l'amplitude Aₘₐₓ, aux oreilles de montage 23 et à l'ensemble support 13 - circuit 15.

On peut encore plus diminuer l'amplitude des vibrations au niveau des éléments fragiles.

Une première solution consiste à supprimer le pincement de l'oreille 23 par ses faces avant et arrière 29, 30, illustré en figures 2 et 4. On pourra ainsi prévoir un léger jeu axial. Toutefois, par la suite, un tel jeu peut s'avérer néfaste puisque le support 13 est alors libre d'effectuer une légère rotation dans un plan horizontal, ce qui, dans certaines applications tout au moins, peut le rendre inapte à remplir une fonction de connecteur. C'est pourquoi dans le mode de réalisation choisi et représenté, il a été jugé préférable de maintenir un contact entre les faces avant 29 et arrière 30 de l'oreille 23 et les faces correspondantes des logements 33a, 33b.

On peut également prévoir, comme illustré sur les figures, d'arrondir les arêtes horizontales de l'oreille 23. Grâce à cette disposition, on évite d'avoir un effet de pointe, c'est-à-dire une concentration d'énergie au niveau de ces arêtes, et une radiation de cette énergie vers l'intérieur du support, lorsque, par exemple, il y a contact entre la face inférieure 27 de l'oreille 23 et la face d'appui 34a du logement 33a de la coquille inférieure 11a.

De plus, dans le mode de réalisation choisi et représenté, selon une caractéristique avantageuse d'un aspect de l'invention, le support, y compris l'oreille de montage 23, est moulé en nylon, cette matière n'étant pas susceptible de pouvoir s'amalgamer à de l'ABS au cours de la soudure. On évite ainsi de bloquer le support 13 dans une position, ce qui permet de maintenir le support libre après le soudage, selon les axes vertical et transversal. De plus on évite qu'en procédant à une microsoudure, au niveau des faces avant 29 ou arrière 30, et en immobilisant de ce fait le support, les vibrations soient transmises à fort niveau vers les éléments fragiles portés par le support 13.

On observera par ailleurs que le fait de laisser subsister un léger jeu dans les sens vertical et transversal permet d'améliorer la tenue de la carte aux efforts de flexion. En effet, si la carte est sensiblement fléchie, l'ensemble du circuit peut se déplacer, dans la limite des jeux sus-mentionnés, pour compenser, autant que possible, la flexion.

Bien entendu la présente invention n'ayant été décrite que dans le cadre d'un mode de réalisation particulier, on pourra en réaliser de nombreuses variantes sans sortir de son cadre.

On observera notamment, que l'invention n'est nullement limitée aux boîtiers minces tels que celui décrit, mais englobe bien au contraire tous types de boîtiers destinés à contenir au moins un élément fragile, que l'on souhaite assembler au moyen d'un procédé de soudure faisant appel à des vibrations d'amplitude dangereuse pour l'élément fragile.

De même l'invention n'est pas limitée aux boîtiers comportant un connecteur apparent. Notamment, elle peut être mise en oeuvre avec une carte porteuse de circuits logiques comportant une connectique de type électromagnétique. Dans un tel cas, tout comme dans tous cas de carte dont la connectique n'est pas apparente, grâce à l'invention on obtient une telle carte présentant l'avantage d'être totalement étanche en plus de tous les avantages sus-mentionnés.

## Revendications

1. Boîtier destiné à contenir, notamment, au moins un élément fragile tel qu'un circuit logique monté sur un support (13), le boîtier comportant le support (13) et au moins deux coquilles (11a, 11b) devant être assemblées par soudure aux ultrasons, caractérisé en ce que chaque coquille comporte à cet effet au moins une zone de soudure (17a, 17b), de géométrie appropriée pour permettre le soudage par ultrasons, et telle que, lorsque les deux coquilles sont préassemblées avant l'opération de soudure, un décalage (21) orienté le long d'un premier axe (20) dit axe vertical sépare globalement les coquilles, et en ce que ledit support (13) comporte au moins une portion de montage (23) tandis que l'une au moins des coquilles comporte un logement (33a, 33b) pour cette portion, les logement et portion de montage coopérant en sorte que, d'une part le débattement du support par rapport aux coquilles le long de deux axes respectivement dits transversal et axial est limité respectivement à un jeu transversal et axial et, d'autre part, après l'opération de soudage, le débattement du support Par rapport aux coquilles le long de l'axe vertical est limité à un jeu vertical (Jv).

2. Boîtier selon la revendication 1, caractérisé en ce que, une fois qu'il est soudé, l'un au moins desdits jeux est nul.

3. Boîtier selon l'une quelconque des revendications 1, 2, caractérisé en ce que la portion de montage comporte une oreille de montage (23), sensiblement parallélépipédique, s'étendant globalement selon un plan transversal - axial tandis que le logement (33a, 33b) est de forme sensiblement complémentaire les dimensions relatives de l'oreille de montage et du logement étant telles que, d'une part, la hauteur de l'oreille est au plus égale à la hauteur totale du logement de cette oreille une fois le boîtier soudé et, que, d'autre part, l'oreille comportant, à son extrémité transversale la plus proche de la zone de soudure, une face latérale (28) orientée selon un plan axial - vertical, aucun contact n'est possible entre cette face latérale et la face correspondante (35a, 35b) du logement (33a, 33b).

4. Boîtier selon l'une quelconque des revendications 1 à 3, caractérisé en ce que la portion de montage du support (13) étant logée dans au moins une encoche (14a, 14b) que comporte l'une au moins des coquilles, deux portions de montage (23) étant prévues, ces portions de montage étant associées chacune à une face latérale d'extrémité (24) du support (13), l'encoche comportant elle-même deux faces latérales correspondantes (41a, 41b), les dimensions relatives de l'encoche et de la portion de montage associée sont telles qu'aucun contact concomitant n'est possible, les faces latérales d'extémité du support ne pouvant être simultanément en contact avec les faces correspondantes de l'encoche.

5. Boîtier selon l'une quelconque des revendications 1 à 4, caractérisé en ce que, la portion de montage (23) comportant un certain nombre d'arêtes, ces dernières sont arrondies.

6. Boîtier selon l'une quelconque des revendications 1 à 5, caractérisé en ce que les coquilles d'un part, et la portion de montage d'autre part, sont réalisées dans des matières distinctes non susceptibles d'être amalgamées au cours d'une opération de soudure aux ultrasons.

7. Procédé d'assemblage d'un boîtier selon l'une quelconque des revendications précédentes, consistant à :
- préassembler les deux coquilles (11a, 11b) et le support (13),
- presser l'une contre l'autre les coquilles au moyen, notamment, d'un dispositif de soudage aux ultrasons,
- faire vibrer la zone de soudure (17a, 17b) au moyen du dispositif de soudage en orientant les vibrations ultrasoniques selon ledit axe vertical,
- arrêter les vibrations des que ledit décalage (21) selon l'axe vertical est annulé.

## Claims

1. A housing designed to contain, in particular, at least one fragile element such as a logic circuit mounted on a support (13), the housing comprising the support (13) and at least two shells (11a, 11b) that have to be assembled by ultrasonic welding, characterized in that each shell comprises for this purpose at least one welding area (17a, 17b), having an appropriate geometry for permitting the ultrasonic welding, and being such that, when both shells are preassembled before the welding phase, a shift (21) directed along a first axis (20), called vertical axis, generally separates the shells, and that said support (13) comprises at least one mounting portion (23) while one at least of the shells comprises a receptacle (33a, 33b) for this portion, the receptacle and mounting portion cooperating in such a way that, on the one hand, the movement of the support with respect to the shells along the two axes respectively called transverse and axial is limited respectively to a transverse and axial clearance and, on the other hand, after the welding phase, the movement of the support with respect to the shells along the vertical axis is limited to a vertical clearance (Jv).

2. A housing according to claim 1, characterized in that, once it is welded, one at least of said clearances is null.

3. A housing according to claim 1 or 2, characterized in that the mounting portion comprises a mounting ear (23), substantially parallelepipedic, generally extending according to a transverse-axial plane, while the receptacle (33a, 33b) has a substantially complementary shape, the relative size of the mounting ear and of the receptacle being such that, on the one hand, the height of the ear is at the most equal to the total height of the receptacle of said ear once the housing is welded and, that, on the other hand, the ear comprising, on its transverse end the nearest to the welding area, a lateral face (28) positioned according to an axial-vertical plane, no contact is possible between this lateral face and the corresponding face (35a, 35b) of the receptacle (33a, 33b).

4. A housing according to any of claims 1 to 3, characterized in that the mounting portion of the support (13) being engaged in at least one notch (14a, 14b) included in at least one of the shells, two mounting portions (23) being provided, each of those mounting portions being associated with an end lateral face (24) of the support (13), the notch comprising two corresponding lateral faces (41a, 41b), the relative size of the notch and of the associated mounting portion is such that no concomitant contact is possible, the end lateral faces of the support not being able to get simultaneously in contact with the corresponding faces of the notch.

5. A housing according to any of claims 1 to 4, characterized in that the mounting portion (23) comprising a given number of edges, the latter are rounded up.

6. A housing according to any of claims 1 to 5, characterized in that the shells on the one hand, and the mounting portion on the other hand, are manufactured from distinct materials not liable to get amalgamated during an ultrasonic welding phase.

7. An assembly method for a housing according to any of the preceding claims, comprising:
- preassembling both shells (11a, 11b) and the support (13),
- pressing together the shells by means, in particular, of an ultrasonic welding device,
- setting the welding area (17a, 17b) in vibration by means of a welding device and directing the ultrasonic vibrations according to said vertical axis,
- stopping the vibrations as soon as said shift (21) according to the vertical axis is cancelled.

## Patentansprüche

1. Gehäuse zur Aufnahme insbesondere zumindest eines zerbrechlichen, auf einem Träger montierten Elementes, z. B. einer logischen Schaltung, wobei das Gehäuse den Träger (13) und zumindest zwei Schalen (11a, 11b) aufweist, die durch Ultraschallschweißung miteinander zu verbinden sind, dadurch gekennzeichnet, daß jede Schale hierzu eine Schweißzone (17a, 17b) mit einer Geometrie aufweist, die für eine Ultraschallschweißung geeignet und so ausgebildet ist, daß dann, wenn die zwei Schalen vor der Schweißung zusammengesetzt sind, die Schalen insgesamt durch einen Versatz (21) getrennt sind, der sich längs einer ersten Achse (20), hier vertikale Achse genannt, erstreckt, und daß der Träger (13) zumindest einen Montageabschnitt (23) und zumindest eine der Schalen eine Aufnahme (33a, 33b) für diesen Abschnitt aufweist, wobei die Aufnahme und der Montageabschnitt derart zusammenarbeiten, daß einerseits die Bewegung des Trägers in Bezug zu den Schalen längs der beiden, hier transversale und axiale Achse genannten Achsen auf ein transversales bzw. axiales Spiel begrenzt ist, und andererseits nach der Verschweißung die Bewegung des Trägers in Bezug zu den Schalen längs der vertikalen Achse auf ein vertikales Spiel (Jv) begrenzt ist.

2. Gehäuse nach Anspruch 1, dadurch gekennzeichnet, daß nach der Verschweißung zumindest eines der Spiele Null ist.

3. Gehäuse nach einem der Ansprüche 1 oder 2, dadurch gekennzeichnet, daß der Montageabschnitt eine Montagelasche (23) mit im wesentlichen Parallelepipedform aufweist, die sich global in einer transversal-axialen Ebene erstreckt, wohingegen die Aufnahme (33a, 33b) von entsprechend komplementärer Form ist und die relativen Dimensionen der Montagelasche und der Aufnahme derart sind, daß einerseits die Höhe der Lasche höchstens gleich der Gesamthöhe der Aufnahme für diese Lasche nach Verschweißen des Gehäuses ist und andererseits die Lasche an ihrem transversalen, der Schweißzone am nächsten liegenden Ende eine Seitenfläche (28) aufweist, die in einer axial-vertikalen Ebene gelegen ist, wobei kein Kontakt zwischen dieser Seitenfläche und der korrespondierenden Fläche (35a, 35b) der Aufnahme (33a, 33b) möglich ist.

4. Gehäuse nach einem der Ansprüche 1 bis 3, dadurch gekennzeichnet, daß der Montageabschnitt des Trägers (13) in zumindest einer Nut, die in zumindest einer der Schalen aufgenommen ist, gelegen ist (14a, 14b), daß zwei Montageahschnitte (23) vorgesehen sind, wobeijeweils einer mit einer äußeren Seitenfläche (24) des Trägers (13) verbunden ist, daß die Nut selbst zwei korrespondierende Seitenflächen (41a, 41b) aufweist, wobei die relativen Dimensionen der Nut und des zugeordneten Montageabschnittes so sind, daß kein gemeinsamer Kontakt möglich ist, und daß die äußeren Seitenflächen des Trägers nicht gleichzeitig in Kontakt mit den korrespondierenden Flächen der Nut sein können.

5. Gehäuse nach einem der Ansprüche 1 bis 4, dadurch gekennzeichnet, daß der Montageabschnitt (23) eine gewisse Anzahl von abgerundeten Kanten aufweist.

6. Gehäuse nach einem der Ansprüche 1 bis 5, dadurch gekennzeichnet, daß die Schalen einerseits und der Montageabschnitt andererseits aus unterschiedlichen Materialien aufgebaut sind, die gegen ein Amalgamieren im Laufe der Ultraschallschweißung unempfindlich sind.

7. Verfahren zur Montage eines Gehäuses nach einem der vorhergehenden Ansprüche, mit den Schritten:
- Zusammensetzen der beiden Schalen (11a, 11b) und des Trägers (13),
- Aneinanderpressen der beiden Schalen insbesondere mittels einer Einrichtung zum Ultraschallschweißen,
- Versetzen der Schweißzone (17a, 17b) in Schwingungen mittels der Schweißeinrichtung, wobei die Schwingungen längs der genannten vertikalen Achse ausgerichtet sind,
- Beenden der Schwingungen, sobald der besagte Versatz (21) längs der vertikalen Achse verschwunden ist.
